# EUROPÄISCHE PATENTSCHRIFT

(11) **EP 3 658 925 B1**
(45) Veröffentlichungstag und Bekanntmachung des Hinweises auf die Patenterteilung: **07.06.2023**
(21) Anmeldenummer: 18721731.0
(22) Anmeldetag: 26.04.2018
(51) Int. Cl.: G01R 31/08, G01R 31/12, G01R 31/14

(54) **VERFAHREN UND PRÜFVORRICHTUNG ZUR MESSUNG VON TEILENTLADUNGSIMPULSEN EINES GESCHIRMTEN KABELS**
METHOD AND TESTING DEVICE FOR MEASURING PARTIAL DISCHARGE PULSES OF A SHIELDED CABLE
PROCÉDÉ ET DISPOSITIF D'ESSAI POUR LA MESURE D'IMPULSIONS DE DÉCHARGE PARTIELLE D'UN CÂBLE BLINDÉ

(30) Priorität: 24.07.2017 DE 102017116613
(43) Veröffentlichungstag der Anmeldung: 03.06.2020
(73) Patentinhaber: Maschinenfabrik Reinhausen GmbH, 93059 Regensburg (DE)
(72) Erfinder: WINKELMANN, Erik, 01099 Dresden (DE)
(86) Internationale Anmeldenummer: PCT/EP2018/060698
(87) Internationale Veröffentlichungsnummer: WO 2019/020225

(56) Entgegenhaltungen:
- EP-A1- 1 012 612
- EP-A1- 3 106 888
- US-B1- 7 112 968
- "IEEE Guide for Partial Discharge Testing of Shielded Power Cable Systems in a Field Environment;IEEE Std 400.3-2006 ED - Anonymous", IEEE STANDARD; [IEEE STANDARD], IEEE, PISCATAWAY, NJ, USA, 5. Februar 2007 (2007-02-05), Seiten c1-36, XP017603950, ISBN: 978-0-7381-5221-9
- TIAN Y ET AL: "Partial discharge detection in high voltage cables using VHF capacitive coupler and screen interruption techniques", CONFERENCE RECORD OF THE 2002 IEEE INTERNATIONAL SYMPOSIUM ON ELECTRICAL INSULATION. (ISEI 2002). BOSTON, MA, APRIL 7 - 10, 2002; [INTERNATIONAL SYMPOSIUM ON ELECTRICAL INSULATION], NEW YORK, NY : IEEE, US, 7. April 2002 (2002-04-07), Seiten 87-90, XP010588802, DOI: 10.1109/ELINSL.2002.995887 ISBN: 978-0-7803-7337-2
- Y Tian ET AL: "Partial discharge detection in cables using VHF capacitive couplers", IEEE Transactions on Dielectrics and Electrical Insulation, Bd. 10, Nr. 2 1. April 2003 (2003-04-01), Seiten 343-353, XP055494603, New York DOI: 10.1109/TDEI.2003.1194121 Gefunden im Internet: URL:https://ieeexplore.ieee.org/ielx5/94/2 6858/01194121.pdf?tp=&arnumber=1194121&isn umber=26858 [gefunden am 2018-07-23]
- "International Standard IEC 60270. High-voltage test techniques - Partial discharge measurements", , 21. Dezember 2000 (2000-12-21), Seiten 1-99, XP055225178, International Electrotechnical Commission, 3, rue de Varemb? Geneva, Switzerland Gefunden im Internet: URL:n.a. [gefunden am 2015-11-02]
- PHUNG B T ET AL: "Practical experience in on-line partial discharge monitoring of power cables", UNIVERSITIES POWER ENGINEERING CONFERENCE, 2008. AUPEC '08. AUSTRALASIAN, IEEE, PISCATAWAY, NJ, USA, 14. Dezember 2008 (2008-12-14), Seiten 1-5, XP031448325, ISBN: 978-0-7334-2715-2
- MACEDO E C T ET AL: "Wavelet transform processing applied to partial discharge evaluation", JOURNAL OF PHYSICS: CONFERENCE SERIES, INSTITUTE OF PHYSICS PUBLISHING, BRISTOL, GB, Bd. 364, Nr. 1, 28. Mai 2012 (2012-05-28), Seite 12054, XP020223136, ISSN: 1742-6596, DOI: 10.1088/1742-6596/364/1/012054

## Beschreibung

Die Erfindung betrifft ein Verfahren und eine Prüfvorrichtung zur Messung von Teilentladungsimpulsen eines geschirmten Kabels, insbesondere zur Bestimmung eines Kennwerts für die scheinbare Ladung eines Teilentladungsimpulses. Die Erfindung ist durch die Gegenstände der Ansprüche 1 (Verfahren) und 12 (entsprechende Vorrichtung) definiert.

Im Folgenden wird wiederholt Bezug genommen auf den internationalen Standard IEC 60270. Ein solcher Bezug ist immer als Bezug auf IEC 60270:2000 + Cor.:2001 + A1:2015 zu verstehen, also auf den Standard in der dritten Ausgabe aus 2000 inklusive des zugehörigen Corrigendum 1 aus 2001 und des Amendment A1 aus 2015. Der deutschsprachige Standard DIN EN 60270:2001 + A1:2016 stimmt damit überein. Falls nicht ausdrücklich abweichend beschrieben, sind alle Begrifflichkeiten, die im Folgenden verwendet werden, im Sinne des Standards IEC 60270 zu verstehen.

Als Teilentladung, TE, wird eine örtlich beschränkte elektrische Entladung bezeichnet, welche die Isolierung zwischen Leitern nur teilweise überbrückt und welche angrenzend an einem Leiter auftreten kann, aber nicht muss. Teilentladungen in geschirmten Kabeln können beispielsweise auf Fehlstellen oder Inhomogenitäten in der elektrischen Isolierung zwischen Seele und Schirm zurückzuführen sein. Teilentladungen tragen zur Alterung der elektrischen Isolierung zwischen Seele und Schirm von geschirmten Kabeln bei und wirken sich daher nachteilig auf deren dielektrische Qualität, insbesondere die Durchschlagsfestig, aus. Um die dielektrische Qualität von geschirmten Kabeln zu gewährleisten werden Teilentladungsmessungen durchgeführt mit Hilfe derer insbesondere ein Kennwert für die scheinbare Ladung einer Teilentladung bestimmt wird.

Solche Teilentladungsmessungen können gemäß IEC 60270 durchgeführt werden. Dabei wird ein Koppelzweig aus einem Koppelkondensator und einer Messimpedanz parallel mit dem Prüfling zwischen einer Hochspannungsquelle und einem Erdanschluss geschaltet. Typischerweise wird die Hochspannungsquelle dabei an der Seele angeschlossen und der Schirm geerdet. Die Empfindlichkeit dieser Anordnung wird dabei maßgeblich durch das Verhältnis der Kapazitäten des Koppelkondensators und des Prüflings bestimmt. Aufgrund der mitunter beträchtlichen Länge der zu prüfenden Kabel (bis zu mehreren km), ist die Kapazität des Koppelkondensators bei der Prüfung von geschirmten Kabeln jedoch in der Regel deutlich kleiner als die Kapazität des Prüflings. Dies führt zu einer beträchtlichen Reduzierung der Empfindlichkeit der Messung. Zudem können Entladungen, die weit entfernt vom Messpunkt auftreten nur zu einem Bruchteil erfasst werden, da entsprechende Teilentladungsimpulse aufgrund der Signaldispersion erheblich gedämpft werden und damit ein großer Teil der Entladungsenergie undetektiert durch die Kapazität zwischen Seele und Schirm und Erdanschluss abfließt. Dies führt zu einer Ungenauigkeit und Unzuverlässigkeit der Messung. Zudem ist eine Ortung der Teilentladung aufgrund der Signaldispersion und Einfluss von Störungen und Rauschen nicht oder nur äußerst ungenau möglich. Die folgenden Dokumente des Standes der Technik sind für die Erfindung relevant:
- "IEEE Guide for Partial Discharge Testing of Shielded Power Cable Systems in a Field Environment", IEEE Std 400.3-2006;
- Y Tian ET AL: "Partial discharge detection in high voltage cables using VHF capacitive coupler and screen interruption techniques", 2002 IEEE INTERNATIONAL SYMPOSIUM ON ELECTRICAL INSULATION (ISEI 2002), 7. April 2002;
- Y Tian ET AL: "Partial discharge detection in cables using VHF capacitive couplers", IEEE Transactions on Dielectrics and Electrical Insulation, 1. April 2003.

Es ist daher eine Aufgabe der vorliegenden Erfindung ein verbessertes Konzept für Teilentladungsmessungen an geschirmten Kabeln anzugeben, das eine erhöhte Empfindlichkeit und Genauigkeit der Messung ermöglicht.

Diese Aufgabe wird durch den Gegenstand der unabhängigen Ansprüche gelöst. Weitere Ausführungsformen sind Gegenstand der abhängigen Ansprüche.

Das verbesserte Konzept betrifft ein Verfahren aus dem Bereich der Hochspannungsprüftechnik sowie eine entsprechende Prüfvorrichtung. Entsprechend sind alle beschriebenen Komponenten als Komponenten zu verstehen, die zur Verwendung in der Hochspannungsprüftechnik geeignet sind. Unter Hochspannung wird eine Spannung von 1000V oder mehr verstanden. Soweit nicht anders beschrieben bedeutet "verbinden" beziehungsweise "Verbindung" immer zumindest auch "elektrisch verbinden" bzw. "elektrische Verbindung".

Das verbesserte Konzept beruht auf der Idee, den Schirm des Kabels bei der Messung nicht mit dem Erdanschluss zu verbinden sondern stattdessen, zusätzlich zu einem an der Seele angeschlossenen oder anschließbaren Koppelzweig, der einen Koppelkondensator und eine Koppeleinheit beinhaltet, mindestens zwei Messzweige vorzusehen, indem mindestens zwei weitere Koppeleinheiten an unterschiedlichen Stellen des Schirms angeschlossen werden können. Dadurch wird zum Einen das Abfließen der Entladungsenergie über den Schirm gegen Erde wirksam unterdrückt, da die Koppeleinheiten aufgrund der hochfrequenten Natur der Teilentladungsimpulse für diese sperrend wirken. Zum anderen liefern die beiden Messzweige Messignale zusätzlich zu dem Messsignal aus dem Koppelzweig. Basierend auf den damit zur Verfügung stehenden Messsignalen kann ein Kennwert für die scheinbare Ladung des Teilentladungsimpulses mit besonders hoher Empfindlichkeit und Genauigkeit bestimmt werden.

Gemäß dem verbesserten Konzept wird ein Verfahren zur Messung von Teilentladungsimpulsen eines geschirmten Kabels, insbesondere zur Bestimmung eines Kennwerts für eine scheinbare Ladung eines Teilentladungsimpulses des Kabels angegeben, das Kabel aufweisend eine Seele und einen Schirm, welche elektrisch voneinander isoliert sind.

Gemäß dem Verfahren wird ein erster Anschluss eines Koppelkondensators mit einer ersten Anschlussstelle der Seele, welche beispielsweise an einem ersten Ende des Kabels angeordnet ist, verbunden. Der Koppelkondensator ist dabei insbesondere als Hochspannungskondensator ausgebildet. Eine erste, eine zweite und eine dritte Koppeleinheit werden bereitgestellt, wobei die Koppeleinheiten jeweils einen Eingang und einen Signalausgang aufweisen.

Der Eingang der ersten Koppeleinheit wird mit einem zweiten Anschluss des Koppelkondensators verbunden. Der Eingang der zweiten Koppeleinheit wird mit einer ersten Anschlussstelle des Schirms und der Eingang der dritten Koppeleinheit mit einer zweiten, insbesondere von der ersten Anschlussstelle räumlich entfernten, Anschlussstelle des Schirms verbunden.

Jeweilige Referenzanschlüsse der Koppeleinheiten können beispielsweise mit einem Referenzpotential verbunden werden, bei welchem es sich beispielsweise um ein Erdpotential handelt. So werden durch die resultierende Reihenschaltung aus Koppelkondensator und erster Koppeleinheit ein Koppelzweig und durch die zweite und dritte Koppeleinheit jeweils ein Messzweig der Prüfvorrichtung gebildet. Im Sprachgebrauch der Hochspannungsprüftechnik können Koppeleinheiten auch als Ankopplungsvierpole bezeichnet werden.

An der ersten Anschlussstelle der Seele wird eine Prüfspannung, insbesondere ein Prüfspannungsimpuls, welcher aus einem oder mehreren Hochspannungseinzelpulsen besteht, bereitgestellt. An dem Signalausgang jeder Koppeleinheit wird ein zugehöriges Messsignal der jeweiligen Koppeleinheit abgegriffen.

Die Prüfspannung ist insbesondere eine Wechselspannung, beispielsweise mit einer Frequenz von 0-500Hz. Jedoch kann in verschiedenen Ausführungsformen alternativ Gleichspannung als Prüfspannung verwendet werden. Die Prüfspannung wird insbesondere durch eine Hochspannungsquelle bereitgestellt, welche direkt oder über wenigstens eine Sperrimpedanz und/oder über ein Eingangsfilter an der ersten Anschlussstelle der Seele angeschlossen wird. Die Sperrimpedanz und/oder der Eingangsfilter können dazu dienen, die Hochspannungsquelle vom restlichen Prüfaufbau zu entkoppeln.

Jede Koppeleinheit ist beispielsweise dazu eingerichtet ein Eingangssignal an ihrem Eingang, insbesondere ein Stromsignal, in das zugehörige Messsignal, welches insbesondere ein Spannungssignal sein kann, an ihrem Signalausgang umzuwandeln. Dabei kann der Strom insbesondere durch einen Teilentladungsimpuls in dem Kabel verursacht werden, der in Folge der Prüfspannung entsteht. Der Koppelkondensator sorgt beispielsweise für das Nachladen einer für den TE-Impuls ursächlichen Fehlstelle.

In Abhängigkeit von den Messsignalen, beispielsweise von einem, zwei oder drei der Messsignale, wird wenigstens ein Kennwert für eine scheinbare Ladung des Teilentladungspulses bestimmt. Der wenigstens eine Kennwert ist beispielsweise gleich der scheinbaren Ladung oder ein Wert proportional zu dieser.

Gemäß wenigstens einer Ausführungsform beinhaltet jede der Koppeleinheiten ein induktives Element, welches zwischen Eingang und Referenzanschluss der jeweiligen Koppeleinheit angeordnet ist. Das induktive Element kann beispielsweise als anpassbare Induktivität ausgebildet sein. Alternativ kann das induktive Element als Stromwandler, insbesondere als Hochfrequenzstromwandler, englisch High Frequency Current Transformer, HFCT, ausgebildet sein.

Durch die Bereitstellung des Koppelzweigs und der beiden Messzweige wird ein mehrkanaliges Messverfahren angegeben, welches insbesondere nach IEC 60270 kalibrierbar ist. Dabei wird die Analogie des Aufbaus des Koppelkondensators und des zu prüfenden geschirmten Kabels, welches ein Objekt mit verteilten Elementen, insbesondere verteilten Widerständen, Kapazitäten und Induktivitäten, darstellt, genutzt. Der aus den verteilten Elementen des Kabels resultierende Induktivitätsbelag und Kapazitätsbelag wird durch das Einbringen der Koppeleinheiten unterstützt. Wie das geschirmte Kabel beinhaltet auch ein Hochspannungskondensator verteilte Kapazitäten und Induktivitäten.

Die induktiven Elemente der Koppeleinheiten bewirken, dass sich sowohl der Koppelzweig als auch die beiden Messzweige für TE-Impulse in dem Sinne sperrend verhalten, dass der TE-Strom nicht oder nur in geringem Maße gegen Erde abfließen kann. Dies liegt darin begründet, dass TE-Impulse naturgemäß sehr kurze Anstiegszeiten in der Größenordnung von 1 ns aufweisen können und daher zu hochfrequenten transienten Impulsen führen, welche beispielsweise Frequenzen im Bereich von 10 kHz bis 10 MHz aufweisen können. Die induktiven Elemente stellen für diese Pulse also eine hohe Impedanz dar. Dadurch, dass der TE-Strom nicht gegen Erde abfließen kann, fließt ein besonders großer Teil des TE-Stroms durch den Koppelkondensator und kann entsprechend mit erhöhter Empfindlichkeit und Genauigkeit von der ersten Koppeleinheit erfasst werden.

Zudem können die zweite und dritte Koppeleinheit ebenfalls jeweils einen Teil des TE-Stroms erfassen, so dass auch die entsprechenden Messsignale zur Bestimmung des Kennwerts für die scheinbare Ladung herangezogen werden können. Dazu können die Messsignale der Koppeleinheiten einzeln als Grundlage dienen oder sie können miteinander verrechnet werden. Dadurch wird die Genauigkeit der Messung weiter erhöht, da zum einen die Wahrscheinlichkeit erhöht wird, dass die TE in räumlicher Nähe zu einer der Koppeleinheiten auftritt und zum anderen auch Einflüsse von Störungen oder Rauschen durch Verrechnung der verschiedenen Messsignale verringert werden können.

Außerdem wird die Auswirkung der Dispersion der TE-Impulse, welche sich aufgrund der Dämpfung durch das Kabel ergibt, verringert, da durch das Vorsehen mehrerer Koppeleinheiten kürzere Signallaufzeiten erzielt werden können.

Erfindungsgemäß werden wenigstens zwei, beispielsweise alle, der Messsignale miteinander verrechnet um den Kennwert für die scheinbare Ladung zu bestimmen.

Gemäß wenigstens einer Ausführungsform beinhaltet jede der Koppeleinheiten ein Filterelement oder Filternetzwerk, welches zwischen Eingang und Signalausgang der jeweiligen Koppeleinheit angeordnet ist. Das Filterelement weist dabei beispielsweise Hochpass- oder Bandpasscharakteristik auf.

Mögliche Grenzfrequenzen für den Hochpass können beispielsweise 30 kHz oder 100 kHz sein. Für den Bandpass wiederum sind beispielsweise 100 kHz als untere Grenzfrequenz und/oder 500 kHz als obere Grenzfrequenz möglich. Andere Grenzfrequenzen sind entsprechend den konkreten Anforderungen möglich.

Gemäß wenigstens einer Ausführungsform sind die Filterelemente der Koppeleinheiten als adaptive Filterelemente ausgebildet und dazu eingerichtet, ihren jeweiligen Frequenzgang an das geschirmte Kabel derart anzupassen, dass Übertragungsfunktionen der Messzweige und des Koppelzweigs einander angeglichen werden.

Gemäß wenigstens einer Ausführungsform ist die erste Anschlussstelle des Schirms an dem ersten Ende des Kabels angeordnet. Gemäß wenigstens einer Ausführungsform ist die zweite Anschlussstelle des Schirms an einem zweiten, von dem ersten Ende verschiedenen, Ende des Kabels angeordnet. Die Anordnung an den Enden des Kabels hat insbesondere den Vorteil, dass an den Enden des Kabels auch die Seelen des Kabels besonders leicht zugänglich sind und daher eine Kalibrierung durch Anschließen eines TE-Kalibrators zwischen Seele und Schirm an einem Ende des Kabels möglich ist, was eine Kalibrierung gemäß IEC 60270 ermöglicht.

Die Auswerteeinheit beinhaltet beispielsweise wenigstens ein TE-Messgerät, insbesondere ein Breitband-TE-Messgerät.

Gemäß zumindest einer Ausführungsform des Verfahrens umfasst das Bestimmen des wenigstens einen Kennwerts für die scheinbare Ladung ein Gewichten des Messsignals der ersten Koppeleinheit. Ferner wird das Messsignal der zweiten Koppeleinheit und/oder das Messsignal der dritten Koppeleinheit gewichtet.

Gemäß zumindest einer Ausführungsform werden jeweilige digitalisierte Messsignale durch analog-digital Wandeln des Messsignals der ersten Koppeleinheit und/der der zweiten Koppeleinheit und/oder der dritten Koppeleinheit erzeugt.

Gemäß zumindest einer Ausführungsform wird ein Differenzsignal durch Subtraktion des gewichteten Messsignals der zweiten Koppeleinheit und/oder des gewichteten Messsignals der dritten Koppeleinheit von dem gewichteten Messsignal der ersten Koppeleinheit gebildet. Alternativ wird das Differenzsignal durch Subtraktion des digitalisierten gewichteten Messsignals der zweiten Koppeleinheit und/oder des digitalisierten gewichteten Messsignals der dritten Koppeleinheit von dem digitalisierten gewichteten Messsignal der ersten Koppeleinheit gebildet. Aus dem Differenzsignal wird dann ein erster Kennwert für die scheinbare Ladung bestimmt.

Gemäß zumindest einer Ausführungsform wird dann zumindest ein Teil des Differenzsignals oder eines von diesem abgeleiteten Signals integriert. Beispielsweise kann eine erste Halbwelle des Differenzsignals integriert werden und/oder wenigstens ein Teil des Absolutbetrags des Differenzsignals und/oder die positiven Flächenanteile des Differenzsignals und/oder die negativen Flächenanteile des Differenzsignals und/oder ein Teil des Fourierspektrums des Differenzsignals.

Das Ergebnis der Integration stellt den ersten Kennwert für die scheinbare Ladung der TE dar. Durch die Verrechnung der verschiedenen Messsignale wird ein besonders großer Anteil der gesamten Entladeenergie der TE berücksichtigt. Dadurch wird eine besonders hohe Genauigkeit der Messung erzielt. Die Genauigkeit ist besonders hoch, wenn alle Messsignale verrechnet werden. Besonders vorteilhaft ist auch, dass bei der Verrechnung auch Einflüsse durch Störungen oder Rauschen verringert werden können. Die Differenzbildung berücksichtigt, dass die Stromrichtung des TE-Stroms aufgrund der beschriebenen Anordnung im Koppelzweig entgegengesetzt zu der in den Messszweigen ist.

Gemäß zumindest einer Ausführungsform beinhaltet das das Bestimmen des wenigstens einen Kennwerts für die scheinbare Ladung das Bestimmen wenigstens eines zweiten Kennwerts für die scheinbare Ladung aus dem Messsignal der zweiten Koppeleinheit und/oder dem Messsignal der dritten Koppeleinheit.

Gemäß zumindest einer Ausführungsform umfasst das Bestimmen eines wenigsten einen zweiten Kennwerts, dass durch analog-digital Wandeln des Messsignals der ersten Koppeleinheit und/oder des Messsignals der zweiten Koppeleinheit und/oder des Messsignals der dritten Koppeleinheit entsprechende digitalisierte Messsignale erzeugt werden. Zumindest ein Teil jedes digitalisierten Messsignals oder eines davon abgeleiteten Signals wird dann integriert. Beispielsweise kann eine erste Halbwelle des digitalisierten Messsignals integriert werden und/oder ein Teil des Absolutbetrags des digitalisierten Messsignals und/oder ein Teil des Fourierspektrums des digitalisierten Messsignals.

Das Ergebnis der Integrationen stellt den wenigstens einen zweiten Kennwert für die scheinbare Ladung der TE dar. Durch die Bestimmung mehrerer Kennwerte für die schweinbare Ladung in der beschriebenen Weise kann, beispielsweise durch Selektion oder Mittelwertbildung, ein verifizierter und besonders genauer Kennwert für die scheinbare Ladung erzielt werden. Beispielsweise können offenbar fehlerhafte oder ungenaue Kennwerte verworfen werden. Aufgrund der Mehrzahl von Koppeleinheiten an unterschiedlichen Positionen des Kabels wird die Wahrscheinlichkeit besonders guter Messwerte erhöht.

Gemäß zumindest einer Ausführungsform umfasst das Bestimmen des wenigstens einen zweiten Kennwerts Gewichten des Messsignals der zweiten Koppeleinheit und des Messsignals der dritten Koppeleinheit und Erzeugen eines Summensignals durch Addition der gewichteten Messsignale der zweiten und der dritten Koppeleinheit oder deren Fourierspektren. Gemäß zumindest einer Ausführungsform wird das Summensignal durch Addition der digitalisierten gewichteten Messsignale der zweiten und der dritten Koppeleinheit oder deren Fourierspektren erzeugt. Der zweite Kennwert wird dann aus dem Summensignal bestimmt.

Gemäß zumindest einer Ausführungsform wird zur Bestimmung des zweiten Kennwerts durch analog-digital Wandeln des Summensignals ein digitalisiertes Summensignal erzeugt.

Zumindest ein Teil jedes Summensignals oder digitalisierten Summensignals oder eines davon abgeleiteten Signals wird dann integriert. Beispielsweise kann eine erste Halbwelle des Summensignals oder digitalisierten Summensignals integriert werden und/oder ein Teil des Absolutbetrags des Summensignals oder digitalisierten Summensignals und/oder die positiven oder negativen Flächenanteile der genannten Signale und/oder ein Teil des Fourierspektrums des Summensignals oder digitalisierten Summensignals.

Das Ergebnis der Integrationen stellt den wenigstens einen zweiten Kennwert für die scheinbare Ladung der TE dar. Durch die Berücksichtigung mehrerer Messsignale wird dadurch eine höhere Genauigkeit der Messung erzielt

Die Gewichtung der Messsignale wird beispielsweise durch Multiplikation der Messsignale mit jeweiligen Gewichtungsfaktoren erreicht, wobei die Gewichtungsfaktoren beispielsweise jeweiligen Kalibrierungsfaktoren aus einer Kalibrierung der jeweiligen Koppeleinheit in der beschriebenen Anordnung entsprechen. Bei einer solchen Kalibrierung wird ein Unterschied zwischen einer tatsächlich an einer Koppeleinheit messbaren Ladung und der scheinbaren Ladung ausgeglichen. Für weitere Einzelheiten wird auf IEC 6027 sowie auf die untenstehende Beschreibung eines Kalibrierungsverfahrens verwiesen.

Gemäß wenigstens einer Ausführungsform werden die Messsignale und/oder das Differenzsignal und/oder das Summensignal vor der analog-digital Wandlung gefiltert, insbesondere durch Tiefpassfilterung, wobei eine Grenzfrequenz der Tiefpassfilterung mit einer Abtastfrequenz, insbesondere einer maximalen Abtastfrequenz, der analog-digital Wandlung übereinstimmt. Dadurch können Alias-Effekte bei der Digitalisierung verringert oder verhindert werden.

Gemäß wenigstens einer Ausführungsform werden das Differenzsignal und/oder das Summensignal und/oder das digitalisierte Summensignal und/oder die digitalisierten Messsignale gefiltert um einen Messbereich zu definieren. Der Messbereich kann beispielsweise im Bereich 0 bis 100 MHz oder im Bereich 0 bis 70 MHz liegen. Vorteilhaft werden dadurch auch Einflüsse von Störsignalen verringert.

Alternativ zu den beschriebenen Integrationen wird in verschiedenen Ausführungsformen ein Scheitelwert des Differenzsignals und/oder des Summensignals und/oder des digitalisierten Summensignals und/oder der digitalisierten Messsignale bestimmt. Der Scheitelwert stellt dann den ersten oder zweiten Kennwert dar.

In verschiedenen Ausführungsformen wird parallel zu oben beschriebenen Pulsauswertung auch jeweils eine Phaseninformation der TE erfasst, insbesondere ein Zeitpunkt der TE bezogen auf die speisende Spannung, welche beispielsweise einer Sinuswelle entspricht. Aus den jeweiligen Phaseninformationen können dann entsprechende phasenaufgelöste Histogramme erzeugt werden, die zur Charakterisierung der TE herangezogen werden können.

Gemäß wenigstens einer Ausführungsform ist die erste Koppeleinheit ausgelegt, einen Strom von 5A oder mehr bei einer Frequenz von 50Hz zu führen. Gemäß wenigstens einer Ausführungsform sind die zweite und dritte Koppeleinheit jeweils ausgelegt, einen Strom von 100A oder mehr, vorzugsweise 200A oder mehr, besonders bevorzugt 500A oder mehr, bei einer Frequenz von 50Hz zu führen. Gemäß wenigstens einer Ausführungsform sind die Koppeleinheiten für Spannungen mit einem Betrag von bis zu 2000V oder mehr ausgelegt.

Gemäß wenigstens einer Ausführungsform werden eine oder mehrere der beschriebenen analog-digital Wandlungen mit einer Synchronität, insbesondere einer Synchronität zwischen den verschiedenen Messzweigen und, falls zutreffend, dem Koppelzweig, von weniger als 15ns, bevorzugt weniger als 10ns, besonders bevorzugt weniger als 5ns durchgeführt.

Gemäß wenigstens einer Ausführungsform wird eine vierte Koppeleinheit mit einem Eingang und einem Signalausgang bereitgestellt, die beispielsweise wie die erste Koppeleinheit ausgebildet ist. Ein weiterer Koppelkondensator wird mit einer zweiten Anschlussstelle der Seele und mit dem Eingang der vierten Koppeleinheit verbunden. Ein Messsignal der vierten Koppeleinheit wird an deren Signalausgang abgegriffen und ein dritter Kennwert für die scheinbare Ladung wird in Abhängigkeit von dem Messsignal der vierten Koppeleinheit bestimmt.

Gemäß wenigstens einer Ausführungsform ist die zweite Anschlussstelle der Seele an dem zweiten Ende des Kabels angeordnet.

Die Bestimmung des dritten Kennwerts kann in einer für die Bestimmung des ersten oder zweiten Kennwerts beschriebenen Weise erfolgen, wobei die vierte Koppeleinheit an die Stelle der ersten Koppeleinheit tritt.

Gemäß wenigstens einer Ausführungsform umfasst das Verfahren das Bestimmen einer ersten Laufzeit aus dem Messsignal der ersten Koppeleinheit und/oder dem Messsignal der zweiten Koppeleinheit. Eine zweite Laufzeit wird aus dem Messsignal der dritten Koppeleinheit bestimmt. Dann wird eine Ortung der TE des Kabels basierend auf der ersten und/oder der zweiten Laufzeit des Kabels durchgeführt.

Die Laufzeiten entsprechen dabei jeweiligen Zeiträumen, die von einem vorgegebenen Referenzzeitpunkt bis zum Zeitpunkt der Erfassung des jeweiligen Messsignals verstreichen, beispielsweise bis zum Auftreten des Scheitelwertes des jeweiligen Messsignals. Die Laufzeiten unterscheiden sich naturgemäß aufgrund der unterschiedlichen räumlichen Entfernung der TE in dem Kabel von den verschiedenen Koppeleinheiten beziehungsweise den zugehörigen Anschlussstellen am Schirm.

Aus der Laufzeit kann daher direkt Rückschluss auf die örtliche Position des Ursprungs der TE im Kabel gezogen werden und die TE so geortet und lokalisiert werden. Insbesondere können die verschiedenen Laufzeiten verglichen werden und eine der Laufzeiten zur Ortung ausgewählt werden, beispielsweise die kürzeste Laufzeit. Dadurch können Dispersionseffekte bei der Messung minimiert und die Messgenauigkeit erhöht werden. Zusätzlich oder alternativ kann die Laufzeit auch anhand anderer Merkmale des jeweiligen Messsignals, beispielsweise der zugehörigen scheinbaren Ladung und/oder des zugehörigen Scheitelwerts, ausgewählt werden um das bestmögliche Messergebnis zu erhalten.

Gemäß wenigstens einer Ausführungsform umfasst das Verfahren das Erzeugen eines korrelierten Signals durch Bilden einer Kreuzkorrelation zwischen den Messsignalen der ersten und der dritten Koppeleinheit oder zwischen den Messsignalen der zweiten und der dritten Koppeleinheit. Aus dem korrelierten Signal wird eine Laufzeit bestimmt und basierend darauf die Ortung der TE vorgenommen.

Alternativ oder zusätzlich zur Laufzeitbestimmung und Ortung kann das korrelierte Signal zur Bestimmung des wenigstens einen Kennwerts für die scheinbare Ladung analog zu dem beschriebenen Vorgehen genutzt werden.

Durch die Kreuzkorrelation werden Störungen und Einflüsse von Rauschen verringert oder beseitigt, was zu einer weiteren Erhöhung der Messgenauigkeit führt.

Gemäß wenigstens einer Ausführungsform werden eine oder mehrere weitere Koppeleinheiten bereitgestellt, die beispielsweise gleich zur zweiten und dritten Koppeleinheit ausgebildet sind. Die weiteren Koppeleinheiten werden mit ihren Eingängen mit jeweiligen weiteren Anschlussstellen des Schirms verbunden, welche vorzugsweise zwischen der ersten und der zweiten Anschlussstelle des Schirms angeordnet sind. Jeweilige Messignale der weiteren Koppeleinheiten werden an deren jeweiligen Signalausgängen abgegriffen und der wenigstens eine Kennwert für die scheinbare Ladung wird in Abhängigkeit von den Messsignalen der weiteren Koppeleinheiten bestimmt.

Bei der Bestimmung des wenigstens eine Kennwerts in Abhängigkeit von den Messsignalen der weiteren Koppeleinheiten werden die Messignale der weiteren Koppeleinheiten analog zu den Messsignalen der zweiten und/oder dritten Koppeleinheit verarbeitet und verwendet wie beschrieben. Insbesondere können die Messignale der weiteren Koppeleinheiten entsprechend gewichtet werden wie beschrieben.

Insbesondere können die Messignale der weiteren Koppeleinheiten bei der Erzeugung des Differenzsignals berücksichtigt werden, indem auch diese von dem Messsignal der ersten Koppeleinheit subtrahiert werden. Alternativ oder zusätzlich können die Messignale der weiteren Koppeleinheiten bei der Bestimmung des zweiten Kennwerts analog zu den Messsignalen der zweiten und/oder dritten Koppeleinheit berücksichtigt werden, insbesondere beim Erzeugen des Summensignals.

Alternativ oder zusätzlich zur Berücksichtigung bei der Bestimmung des wenigstens einen Kennwerts für die scheinbare Ladung wird gemäß wenigstens einer Ausführungsform die Ortung der TE in Abhängigkeit der Messignale der weiteren Koppeleinheiten durchgeführt. Dazu wird für jedes der Messignale der weiteren Koppeleinheiten eine entsprechende Laufzeit bestimmt, wie oben beschrieben.

Gemäß wenigstens einer Ausführungsform werden die zu den Messignale der weiteren Koppeleinheiten gehörigen Laufzeiten analog zu den aus den Messsignalen der zweiten und/oder dritten Koppeleinheit verwendet um die TE zu orten.

Gemäß wenigstens einer Ausführungsform sind die jeweiligen Anschlussstellen am Schirm, mit denen die zweite, die dritte und die weiteren Koppeleinheiten verbunden sind, äquidistant angeordnet.

Gemäß wenigstens einer Ausführungsform werden wenigstens drei Laufzeiten miteinander verglichen, die unterschiedlichen Anschlussstellen am Schirm beziehungsweise entsprechenden Koppeleinheiten zugeordnet sind. Die Ortung der TE umfasst dann eine räumliche Eingrenzung der TE auf eine Position zwischen denjenigen Anschlussstellen am Schirm, für die die beiden kürzesten Laufzeiten bestimmt wurden. Dadurch ist die Ortung besonders einfach und beispielsweise ohne weitere Rechenschritte möglich. Außerdem kann der Teil des Kabels in dem die TE geortet wurde ausgetauscht oder entfernt werden. Je höher die Zahl der weiteren Koppeleinheiten, desto kleiner ist vorteilhafter Weise der zu entfernende Teil des Kabels.

Durch das Vorsehen der Vielzahl von Koppeleinheiten wird der Einfluss von Signaldispersion reduziert. Ferner wird dadurch eine Echtzeitanzeige eines Ergebnisses der Ortung der TE ermöglicht.

Gemäß wenigstens einer Ausführungsform umfasst das Verfahren das Kalibrieren, insbesondere nach IEC 60270 oder teilweise nach IEC 60270, wenigstens einer der Koppeleinheiten, insbesondere in dem beschriebenen Prüfaufbau, bevor die Schritte der Bereitstellung der Prüfspannung, des Abgreifens der Messsignale und des Bestimmens des wenigstens einen Kennwerts durchgeführt werden.

Gemäß wenigstens einer Ausführungsform umfasst das Kalibrieren das Bestimmen eines Kalibrierfaktors für wenigstens eine der Koppeleinheiten. Der Kalibrierfaktor entspricht beispielsweise dem Gewichtungsfaktor zur beschriebenen Gewichtung des Messsignals der Koppeleinheit.

Gemäß wenigstens einer Ausführungsform wird bei dem Kalibrieren ein Kalibrierimpuls zwischen der ersten Anschlussstelle der Seele und einem der Eingänge der Koppeleinheiten und/oder zwischen der zweiten Anschlussstelle der Seele und einem der Eingänge der Koppeleinheiten und/oder zwischen einer weiteren Anschlussstelle der Seele und einem der Eingänge der Koppeleinheiten erzeugt. Dabei entspricht die weitere Anschlussstelle der Seele insbesondere einer Anschlussstelle, mit der eine der Koppeleinheiten verbunden ist. Ein Kalibrationssignal, welches insbesondere auf den Kalibrierimpuls zurückgeht, wird an dem Signalausgang wenigstens einer der Koppeleinheiten abgegriffen. Ein Prüfwert für die scheinbare Ladung des Kalibrierumpulses wird aus dem Kalibrationssignal bestimmt. Der Prüfwert wird mit einem Referenzwert für die scheinbare Ladung des Kalibrierimpulses verglichen und aus dem Vergleich wird der Kalibrierfaktor für die Koppeleinheit bestimmt, wobei der Kalibrierfaktor insbesondere einem Verhältnis zwischen Prüfwert und Referenzwert oder einem zu dem Verhältnis proportionalen Wert entspricht.

Gemäß wenigstens einer Ausführungsform umfasst das Bestimmen des Prüfwerts das Erzeugen eines digitalisierten Kalibrationssignals durch analog-digital Wandeln des Kalibrationssignals und integrieren zumindest eines Teils des digitalisierten Kalibrationssignals oder eines von diesem abgeleitetem Signals. Die Integration wird beispielsweise durchgeführt wie bezüglich des Differenzsignals und/oder der Messsignale beschrieben. Die verschiedenen Möglichkeiten zur Filterung die bezüglich des Differenzsignals und/oder der Messsignale beschrieben wurde ist entsprechend für das Kalibrationssignal möglich. Das Ergebnis der Integrationen stellt den Kalibrierfaktor dar.

Vorzugsweise wird die Integration des digitalisierten Kalibrationssignals in derselben Weise durchgeführt wie die Integration des Differenzsignals und/oder Summensignals und/oder der digitalisierten Messsignale.

Gemäß wenigstens einer Ausführungsform beinhaltet die Bestimmung des Referenzwerts die Erzeugung eines Kalibriersignals zwischen Eingang der Koppeleinheit und dem Referenzpotential, wobei die Koppeleinheit nicht mit dem Kabel, der Hochspannungsquelle, dem Koppelkondensator oder einer anderen Komponente der beschriebenen Prüfvorrichtung verbunden ist. Ein Referenzsignal wird dann an dem Signalausgang der Koppeleinheit abgegriffen und der Referenzwert wird analog zur beschriebenen Bestimmung des Kalibrierfaktors bestimmt.

Gemäß zumindest einer Ausführungsform befindet sich die weitere Anschlussstelle der Seele an einer Position der Seele, die der Position der Anschlussstelle des Schirms entspricht mit welcher der Eingang der Koppeleinheit, welche kalibriert wird, verbunden ist.

In verschiedenen Ausführungsformen wird bei der Kalibrierung wenigstens eine Übertragungsfunktion zwischen zwei der Anschlussstellen des Schirms und/oder der Seele ermittelt. Da der Kalibrierimpuls ein weitgehend konstantes Spektrum, insbesondere von 0 bis etwa 10 MHz, aufweist, stellt ein Fourierspektrum des an dem Signalausgang der wenigstens einen Koppeleinheit abgegriffenen Kalibriersignals eine Sprungantwort und somit eine Übertragungsfunktion dar. Dabei handelt es sich um eine Übertragungsfunktion zwischen der Anschlussstelle, an welcher der Kalibrator mit dem Kabel verbunden ist und der Anschlussstelle, an welcher die genannte Koppeleinheit mit dem Kabel verbunden ist. Durch die Kalibrierung kann damit effektiv eine Vermessung der Übertragungseigenschaften des Kabels durchgeführt werden.

Falls die Anschlussstelle des Schirms nicht an einem Ende des Kabels angeordnet ist, kann die Seele beispielsweise mittels einer Muffe kontaktiert werden, mit welcher der Kalibrator verbunden wird. Insbesondere kann die Kalibrierung beim Einbau der Muffe durchgeführt werden.

Zur Erzeugung des Kalibrierimpulses wird beispielsweise ein Kalibrator, insbesondere ein Kalibrator gemäß IEC 60270, verwendet. Der Kalibrator kann beispielsweise eine Generator sein, der eine Sprungspannung erzeugt, und einem damit in Reihe geschalteten Kondensator umfassen, so dass der Kalibrierimpuls aus einer Folge von Strom- oder Spannungsimpulsen mit vorgegebener Stärke besteht.

Durch das beschriebene Kalibrieren kann für jede Koppeleinheit eine Mehrzahl von Kaibrierfaktoren entsprechend der verschiedenen möglichen Anordnungen des Kalibrators bestimmt werden. Aus dieser Mehrzahl von Kalibrierfaktoren kann dann für die Gewichtung des Messsignals der Koppeleinheit ein besonders geeigneter Kalibrierfaktor ausgewählt werden, beispielsweise entsprechend einer Anordnung des Kalibrators möglichst nahe an der Anschlussstelle des Schirms mit dem die Koppeleinheit verbunden ist. Alternativ kann ein Mittelwert aus mehreren Kalibrierfaktoren zur Gewichtung verwendet werden.

Auf diese Weise wird eine besonders genaue Kalibrierung, insbesondere nach IEC 60270, der TE-Messung erreicht.

Gemäß dem verbesserten Konzept wird außerdem eine Prüfvorrichtung zur Messung von Teilentladungsimpulsen eines geschirmten Kabels angegeben, das Kabel aufweisend eine Seele und einen Schirm. Die Prüfvorrichtung umfasst eine erste, eine zweite und eine dritte Koppeleinheit, einen Koppelkondensator, eine Hochspannungsquelle und eine Auswerteeinheit. Der Eingang der zweiten Koppeleinheit ist mit einer ersten Anschlussstelle des Schirms verbindbar oder verbunden und der Eingang der dritten Koppeleinheit ist mit einer zweiten Anschlussstelle des Schirms verbindbar oder verbunden.

Die Hochspannungsquelle weist einen Ausgang zum Anschließen der Hochspannungsquelle an eine erste Anschlussstelle der Seele auf. Ein erster Anschluss des Koppelkondensators ist mit dem Ausgang der Hochspannungsquelle verbunden und der Eingang der ersten Koppeleinheit ist mit einem zweiten Eingang des Koppelkondensators verbunden.

Die Auswerteeinheit ist mit jedem der Signaleingänge der ersten, der zweiten und der dritten Koppeleinheit verbunden. Die Auswerteeinheit ist dazu eingerichtet, von den Signalausgängen der Koppeleinheiten zugehörige Messsignale zu erhalten und in Abhängigkeit von den Messsignalen wenigstens einen Kennwert für eine scheinbare Ladung eines Teilentladungsimpulses des Kabels zu bestimmen.

Die Auswerteeinheit ist dazu eingerichtet, den wenigstens einen Kennwert nach einem Verfahren gemäß dem verbesserten Konzept zu bestimmen und/oder die Ortung der TE nach einem Verfahren gemäß dem verbesserten Konzept durchzuführen.

Gemäß entsprechenden Ausführungsformen ist die Auswerteeinheit dazu eingerichtet die verschiedenen beschriebenen Filterungen und sonstigen Signalverarbeitungsschritte durchzuführen.

Gemäß wenigstens einer Ausführungsform umfasst die Prüfvorrichtung eine vierte Koppeleinheit, die einen Eingang und einen Signalausgang aufweist, und einen weiteren Koppelkondensator verbindbar mit einer zweiten Anschlussstelle der Seele, wobei der Eingang der vierten Koppeleinheit mit dem weiteren Koppelkondensator verbunden ist. Die Auswerteeinheit ist dazu eingerichtet ist, von dem Signalausgang der vierten Koppeleinheit ein Messsignal zu erhalten und den wenigstens einen Kennwert für eine scheinbare Ladung in Abhängigkeit von dem Messsignal der vierten Koppeleinheit zu bestimmen.

Die beschriebene Kalibrierung kann für die Prüfvorrichtung analog angewendet werden.

Gemäß dem verbesserten Konzept wird außerdem eine Prüfanordnung angegeben, die eine Prüfvorrichtung nach dem verbesserten Konzept sowie das geschirmte Kabel umfasst. Die mit dem Kabel verbindbaren Komponenten der Prüfvorrichtung sind mit dem Kabel verbunden.

Weitere Ausgestaltungsformen und Implementierungen des Prüfsystems ergeben sich unmittelbar aus den verschiedenen Ausgestaltungsformen des Verfahrens zur Messung von Teilentladungsimpulsen. Insbesondere können einzelne oder mehrere der bezüglich des Verfahrens beschriebenen Komponenten und/oder Anordnungen zur Durchführung des Verfahrens in dem Prüfsystem entsprechend implementiert sein.

Im Folgenden wird die Erfindung anhand beispielhafter Ausführungsformen unter Bezug auf die Zeichnungen im Detail erklärt. Komponenten, die funktionell identisch sind oder einen identischen Effekt haben, können mit identischen Bezugszeichen versehen sein. Identische Komponenten oder Komponenten mit identischer Funktion sind unter Umständen nur bezüglich der Figur erklärt, in der sie zuerst erscheinen. Die Erklärung wird nicht notwendigerweise in den darauffolgenden Figuren wiederholt.

Es zeigen
- Figur 1: ein Blockschaltbild einer beispielhaften Ausführungsform einer Prüfvorrichtung gemäß dem verbesserten Konzept mit einem geschirmten Kabel;
- Figur 2A: ein Blockschaltbild einer beispielhaften Ausgestaltung einer Koppeleinheit für eine Prüfvorrichtung oder ein Verfahren gemäß dem verbesserten Konzept;
- Figur 2B: ein Blockschaltbild einer weiteren beispielhaften Ausgestaltung einer Koppeleinheit für eine Prüfvorrichtung oder ein Verfahren gemäß dem verbesserten Konzept; und
- Figur 3: eine schematische Darstellung einer weiteren beispielhaften Ausführungsform einer Prüfvorrichtung gemäß dem verbesserten Konzept mit einem geschirmten Kabel.

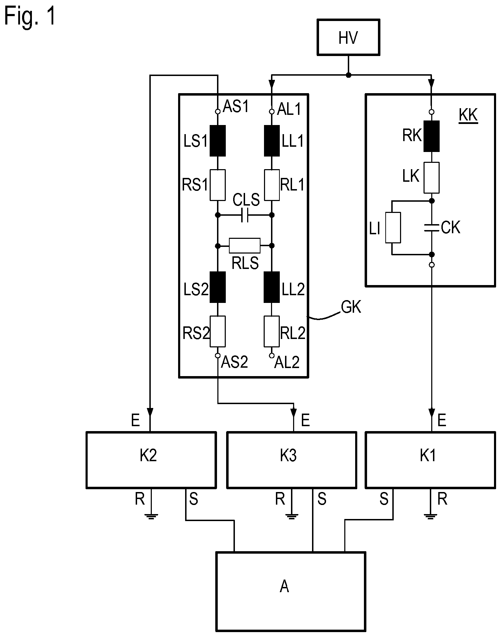

In Figur 1 ist ein Blockschaltbild einer beispielhaften Ausführungsform einer Prüfvorrichtung gemäß dem verbesserten Konzept gezeigt sowie ein Ersatzschaltbild eines geschirmten Kabels GK mit dem die abgebildete Prüfvorrichtung hier beispielhaft verbunden ist. Die Prüfvorrichtung aus Figur 1 kann für ein Verfahren gemäß dem verbesserten Konzept verwendet werden.

Das Kabel GK beinhaltet einen inneren Leiter, welcher als Seele bezeichnet wird und in dem Ersatzschaltbild durch eine Reihenschaltung aus einer ersten Leiterinduktivität LL1, einem ersten Leiterwiderstand RL1, einerzweiten Leiterinduktivität LL2 und einem zweiten Leiterwiderstand RL2 dargestellt ist. Ferner weist das Kabel GK einen elektrisch leitenden Schirm auf, welcher durch eine Reihenschaltung aus einer ersten Schirminduktivität LS1, einem ersten Schirmwiderstand RS1, einerzweiten Schirminduktivität LS2 und einem zweiten Schirmwiderstand RS2 dargestellt ist. Schirm und innerer Leiter sind voneinander elektrisch isoliert, was durch eine Leiter-Schirm Kapazität CLS sowie einen parallel dazu angeordneten Leiter-Schirm Widerstand RLS im Ersatzschaltbild berücksichtigt ist. Leiter-Schirm Kapazität CLS und Leiter-Schirm Widerstand RLS sind beispielsweise zwischen den Reihenschaltungen, welche die Seele beziehungsweise den Schirm repräsentieren angeordnet. Das Ersatzschaltbild entspricht daher beispielsweise und nicht beschränkend einem einseitig offenen Kabel GK. Alternativ ist ein Abschluss des Kabels, beispielsweise mit einem Endverschluss oder einem Wasserendverschluss und/oder einem zusätzlichen Hochspannungskondensator, möglich.

Die Seele weist eine erste Anschlussstelle AL1 auf, die beispielhaft an einem ersten Ende des Kabels angeordnet ist. Der Schirm weist eine erste und eine zweite Anschlussstelle AS1, AS2, die beispielhaft an dem ersten beziehungsweise dem zweiten Ende des Kabels angeordnet sind.

Die Prüfvorrichtung weist eine Hochspannungsquelle HV, einen Koppelkondensator KK, eine Auswerteeinheit A und beispielhaft eine erste, zweite und dritte Koppeleinheit K1, K2, K3 auf. Ein Ausgang der Hochspannungsquelle HV ist mit dem ersten Anschluss AL1 der Seele und einem ersten Anschluss des Koppelkondensators KK verbunden. Ein zweiter Anschluss des Koppelkondensators ist mit einem Eingang E der ersten Koppeleinheit K1 verbunden, deren Referenzanschluss R mit einem Erdpotential verbunden ist. Dadurch wird ein Koppelzweig aus der Reihenschaltung aus Koppelkondensator KK und erster Koppeleinheit K1 gebildet. Eingänge E der zweiten und dritten Koppeleinheit K2, K3 sind mit der ersten beziehungsweise zweiten Anschlussstelle AS1, AS2 des Schirms verbunden. Referenzanschlüsse R der zweiten und dritten Koppeleinheit K2, K3 sind mit dem Erdpotential verbunden, wodurch ein erster und ein zweiter Messzweig gebildet werden. Signalausgänge S der Koppeleinheiten K1, K2, K3 sind mit der Auswerteeinheit A verbunden. Die Prüfvorrichtung kann optional weitere Koppeleinheiten aufweisen, die mit weiteren Anschlussstellen des Schirms verbunden sind.

Die Hochspannungsquelle HV ist eingerichtet, eine Prüfspannung an ihrem Ausgang zu erzeugen, welche einen Prüfstrom zur Folge hat, welcher sich zwischen Koppelzweig und Kabel GL aufteilt, wie durch Pfeile angedeutet. Der Prüfstrom wird im Wesentlichen von der Leiter-Schirm Kapazität CLS bestimmt. Der Leiter-Schirm Widerstand RLS des isolierenden Dielektrikums zwischen Seele und Schirm ist sehr hoch, so dass über ihn nur ein vernachlässigbarer Teil des Prüfstroms fließt.

Der Koppelkondensator KK ist als Hochspannungskondensator ausgebildet und beinhaltet beispielsweise eine Mehrzahl in Reihe geschalteter Kondensatorwickel. Die Kondensatorwickel sind beispielsweise als aufgewickelte Schichten aus einem Dielektrikum mit zwei leitenden Folien ausgeformt. In Figur 1 ist der Koppelkondensator KK durch ein beispielhaftes Ersatzschaltbild dargestellt. Verbindungen zwischen den Kondensatorwickeln und von den Kondensatorwickeln zu den Anschlüssen des Kondensators sind durch eine Reihenschaltung aus einer Verbindungsinduktivität LK und einem Verbindungswiderstand RK berücksichtigt. Mit diesen in Reihe geschaltet ist die Kapazität CK des Kondensators, welche durch das Dielektrikum gebildet wird. Die Selbstinduktivität der Kondensatorwickel LI ist parallel zu der Kapazität CK des Kondensators geschaltet.

Kommt es zu einer Teilentladung, TE, in dem Kabel GK, insbesondere in der elektrischen Isolation zwischen Schirm und Seele, führt dies zu einem, insbesondere hochfrequenten und/oder transienten, Teilentladungsstrom beziehungsweise -impuls sowohl im Koppelzweig als auch in allen Messzweigen. Die Koppeleinheiten K1, K2, K3 weisen beispielsweise ein induktives Element zwischen Eingang E und Referenzanschluss R auf und verhalten sich im Frequenzbereich der TE-Impulse induktiv, so dass sie sperrend wirken insbesondere für Signale im hohen zweistelligen und dreistelligen KHz-Bereich. Durch das Einbringen der Koppeleinheiten K1, K2, K3 zwischen Schirm und Seele haben also sowohl die Messzweige wie auch der Zweig, der durch erste Leiterinduktivität LL1, Leiter-Schirm Kapazität CLS, zweite Schirminduktivität LS2 und Eigeninduktivität der dritten Koppelinduktivität K3 gebildet wird, eine hohe Impedanz und eine entsprechende Sperrwirkung für TE-Impulse. Der TE-Strom fließt dadurch zu einem besonders hohen Teil durch den Koppelkondensator KK, was zu einer verbesserten Messempfindlichkeit führt. Anders ausgedrückt teilt sich der TE-Strom zwischen den Messzweigen besonders günstig für eine genaue Messung auf, da alle Messzweige und der Koppelzweig über eine Koppeleinheit verfügen. Erfindungsgemäß ist dann der Schirm wie der Koppelkondensator KK nicht direkt geerdet, sondern über eine der Koppeleinheiten K2, K3 mit ihrer jeweiligen Eigeninduktivität.

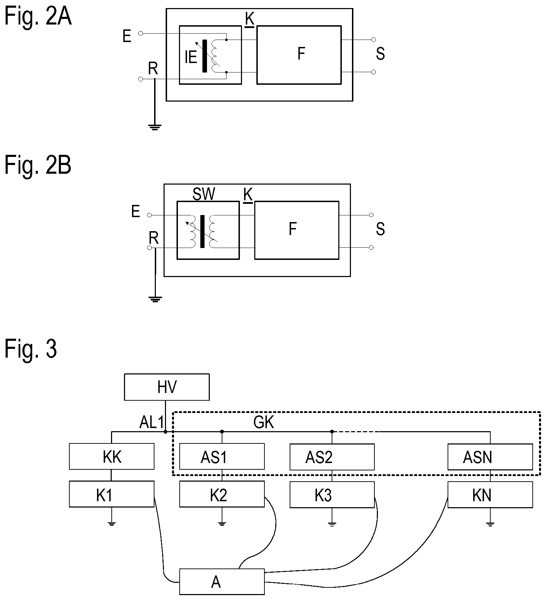

Figur 2A zeigt ein Blockschaltbild einer beispielhaften Ausgestaltung einer Koppeleinheit K für eine Prüfvorrichtung oder ein Verfahren gemäß dem verbesserten Konzept.

Die Koppeleinheit K ist als Messimpedanz ausgebildet. Sie beinhaltet eine, vorzugsweise anpassbare, Induktivität IE sowie ein der Induktivität IE nachgeschaltetes Filterelement F. Das Filterelement F ist beispielsweise als Filternetzwerk ausgebildet, zum Beispiel als RLC Netzwerk, welches optional seine Transferfunktion anpassen kann. Die Koppeleinheit K hat einen Eingang E und einen Referenzanschluss R, zwischen denen die Induktivität IE geschaltet ist, sowie einen Signalausgang S zur Ausgabe eines Messsignals. Die Koppeleinheit K ist hier beispielsweise zur Ausgabe eines differenziellen Signals an zwei Anschlüssen des Signalausgangs S eingerichtet.

Figur 2B zeigt ein Blockschaltbild einer weiteren beispielhaften Ausgestaltung einer Koppeleinheit K für eine Prüfvorrichtung oder ein Verfahren gemäß dem verbesserten Konzept.

Die Koppeleinheit K umfasst einen Stromwandler SW, welcher beispielsweise als Hochfrequenzstromwandler, englisch High Frequency Current Transformer, HFCT, ausgebildet ist und das induktive Element der Koppeleinheit K darstellt. Der Stromwandler SW kann beispielsweise als Durchsteckwandler mit einer Primärwindungszahl von 1 ausgebildet sein.

Die in Figuren 2A und 2B gezeigten Koppeleinheiten K können als Koppeleinheiten in einer Prüfvorrichtung beziehungsweise in einem Verfahren nach dem verbesserten Konzept verwendet werden.

Figur 3 zeigt schematische Darstellung einer weiteren beispielhaften Ausführungsform einer Prüfvorrichtung gemäß dem verbesserten Konzept sowie eines geschirmten Kabels GK mit dem die abgebildete Prüfvorrichtung hier beispielhaft verbunden ist.

Das geschirmte Kabel GK weist eine erste Anschlussstelle AL1 der Seele und eine Vielzahl von N Anschlussstellen AS1, AS2, ..., ASN des Schirms auf, von denen drei abgebildet sind. Wie durch die gestrichelte Unterbrechung angedeutet, kann das Kabel GK weitere Anschlussstellen des Schirms aufweisen.

Wie in Figur 1 sind die Hochspannungsquelle HV und die Reihenschaltung aus Koppelkondensator KK und erster Koppeleinheit K1 mit der ersten Anschlussstelle AL1 der Seele verbunden. Die Prüfvorrichtung weist eine Vielzahl von weiteren Koppeleinheiten K2, K3, ..., KN auf, von denen beispielhaft drei gezeigt sind, und die mit einem jeweiligen Eingang jeweils mit einer der Anschlussstellen des Schirms AS1, AS2, ..., ASN und mit einem jeweiligen Referenzanschluss mit einem Referenzpotential, beispielsweise einem Erdpotential, verbunden sind. Die Auswerteeinheit A ist mit einem zugehörigen Signalausgang jeder der Koppeleinheiten verbunden.

Durch diese Anordnung kann ein mehrkanaliges Messverfahren angewendet werden, wie weiter oben für das Verfahren nach dem verbesserten Konzept beschrieben, welches insbesondere nach IEC 60270 kalibrierbar ist. Das Kabel wird effektiv in eine Vielzahl von Kabelzweigen zwischen den Anschlussstellen AS1, AS2, ..., ASN, AL1 des Schirms und der Seele aufgeteilt. Ein in den Kabelzweigen und im Koppelzweig fließender Prüfstrom ist von der Prüfspannung sowie von den jeweils wirksamen Kapazitäten abhängig. Bei Frequenzen im dreistelligen Hz Bereich verhält sich der Prüfaufbau im Wesentlichen kapazitiv. Im Frequenzbereich einer breitbandigen TE-Messung nach IEC 60270, beispielsweise im dreistelligen kHz- und darüber liegenden Bereich, wird der bei kleinen Frequenzen vernachlässigbare Induktivitätsbelag des Kabels GK wirksam.

Durch Anwendung des Verfahrens nach dem verbesserten Konzept wird damit eine besonders hohe Messempfindlichkeit und -genauigkeit ermöglicht.

Durch das verbesserte Konzept wird ein Verfahren und eine Prüfvorrichtung zur hochsensitiven TE-Messung an geschirmten Kabeln oder anderen Objekten mit verteilten Elementen angegeben, wodurch eine erhöhte Empfindlichkeit erzielt werden kann. Ein Grundstörpegel der TE-Messung kann deutlich reduziert werden. TE, die weit entfernt vom ersten Ende des Kabels auftreten können deutlich besser detektiert werden. Durch die weniger ins Gewicht fallende Signaldispersion ist eine genauere Fehlerortung möglich.

Das verbesserte Konzept wurde hier für geschirmte Kabel beschrieben. Jedoch ist die analoge Anwendung auf andere Objekte mit verteilten Elementen, beispielsweise verteilten Kapazitäten, Induktivitäten und/oder Widerständen, für den Fachmann ohne weiteres möglich und bietet entsprechende Vorteile wie bei der Anwendung an geschirmten Kabeln. Solche Objekte mit verteilten Elementen können beispielsweise Hochspannungskondensatoren, ausgedehnte gasisolierte Schaltanlagen, GIS, oder Hochspannungsdurchführungen sein.

### BEZUGSZEICHEN

- HV: Hochspannungsquelle
- GK: geschirmtes Kabel
- KK: Koppelkondensator
- A: Auswerteeinheit
- K1, K2, K3, KN, K: Koppeleinheiten
- AS1, AS2, ASN: Anschlussstellen des Schirms
- AL1, AL2: Anschlussstellen der Seele
- RK: Verbindungswiderstand
- LK: Verbindungsinduktivität
- LI: Selbstinduktivität der Kondensatorwickel
- CK: Kapazität des Koppelkondensators
- LS1, LS2: Schirminduktivitäten
- RS1, RS2: Schirmwiderstände
- LL1,LL2: Leiterinduktivitäten
- RL1, RL2: Leiterwiderstände
- CLS: Leiter-Schirm Kapazität
- RLS: Leiter-Schirm Widerstand
- IE: induktives Element
- SW: Stromwandler
- F: Filterelement
- E: Eingang
- R: Referenzanschluss
- S: Signalausgang

## Patentansprüche

1. Verfahren zur Messung von Teilentladungsimpulsen eines geschirmten Kabels (GK) mit einer Seele und einem Schirm, das Verfahren umfassend:
- Verbinden eines Koppelkondensators (KK) mit einer ersten Anschlussstelle (AL1) der Seele;
- Bereitstellen einer ersten, einer zweiten und einer dritten Koppeleinheit (K1, K2, K3), wobei die Koppeleinheiten (K1, K2, K3) jeweils einen Eingang (E) und einen Signalausgang (S) aufweisen;
- Verbinden des Eingangs (E) der ersten Koppeleinheit (K1) mit dem Koppelkondensator (KK), des Eingangs (E) der zweiten Koppeleinheit (K2) mit einer ersten Anschlussstelle (AS1) des Schirms und des Eingangs (E) der dritten Koppeleinheit (K3) mit einer zweiten Anschlussstelle(AS2) des Schirms derart, dass der Schirm nicht direkt, sondern über die zweite und die dritte Koppeleinheit (K2, K3) geerdet ist;
- Bereitstellung einer Prüfspannung an der ersten Anschlussstelle (AL1) der Seele;
- Abgreifen von wenigstens zwei Messsignalen der Koppeleinheiten (K1, K2, K3) an den Signalausgängen (S) der Koppeleinheiten (K1, K2, K3);
- Bestimmen wenigstens eines Kennwerts für eine scheinbare Ladung eines Teilentladungsimpulses des Kabels (GK) in Abhängigkeit von den Messsignalen;
wobei
- wenigstens zwei der Messsignale miteinander verrechnet werden.

2. Verfahren nach Anspruch 1, wobei das Bestimmen des wenigstens einen Kennwerts für die scheinbare Ladung umfasst:
- Gewichten des Messsignals der ersten Koppeleinheit (K1);
- Gewichten des Messsignals der zweiten Koppeleinheit (K2) und/oder des Messsignals der dritten Koppeleinheit (K3);
- Erzeugen eines Differenzsignals
- durch Subtrahieren des gewichteten Messsignals der zweiten und/oder der dritten Koppeleinheit (K2, K3) von dem gewichteten Messsignal der ersten Koppeleinheit (K1); oder
- durch Subtrahieren eines digitalisierten gewichteten Messsignals der zweiten und/oder der dritten Koppeleinheit (K2, K3) von einem digitalisierten gewichteten Messsignal der ersten Koppeleinheit (K1); und
- Bestimmen eines ersten Kennwerts für die scheinbare Ladung aus dem Differenzsignal.

3. Verfahren nach Anspruch 2, wobei das Bestimmen des ersten Kennwerts für die scheinbare Ladung aus dem Differenzsignal eine Integration zumindest eines Teils des Differenzsignals oder eines von dem Differenzsignal abgeleitetem Signal umfasst.

4. Verfahren nach einem der Ansprüche 1 bis 3, wobei das Bestimmen des wenigstens einen Kennwerts für die scheinbare Ladung das Bestimmen wenigstens eines zweiten Kennwerts für die scheinbare Ladung aus dem Messsignal der zweiten Koppeleinheit (K2) und/oder dem Messsignal der dritten Koppeleinheit (K3) umfasst.

5. Verfahren nach Anspruch 4, wobei das Bestimmen des wenigstens einen zweiten Kennwerts für die scheinbare Ladung umfasst:
- Gewichten des Messsignals der zweiten Koppeleinheit (K2) und des Messsignals der dritten Koppeleinheit (K3);
- Erzeugen eines Summensignals durch Addition der gewichteten Messsignale der zweiten und der dritten Koppeleinheit (K2, K3) oder der Fourierspektren der gewichteten Messignale der zweiten und der dritten Koppeleinheit (K2, K3); und
- Bestimmen des zweiten Kennwerts für die scheinbare Ladung aus dem Summensignal.

6. Verfahren nach einem der Ansprüche 1 bis 5, außerdem umfassend:
- Bereitstellen einer vierten Koppeleinheit, die einen Eingang (E) und einen Signalausgang (S) aufweist;
- Verbinden eines weiteren Koppelkondensators mit einer zweiten Anschlussstelle der Seele (AL2) und des Eingangs der vierten Koppeleinheit mit dem weiteren Koppelkondensator;
- Abgreifen von eines Messsignalen der vierten Koppeleinheit an dem Signalausgang (S) der vierten Koppeleinheit;
- Bestimmen eines dritten Kennwerts für die scheinbare Ladung in Abhängigkeit von dem Messsignal der vierten Koppeleinheit.

7. Verfahren nach Anspruch 6, wobei das Bestimmen des dritten Kennwerts für die scheinbare Ladung umfasst:
- Gewichten der Messsignale der dritten (K3) und der vierten Koppeleinheit;
- Erzeugen eines weiteren Differenzsignals
- durch Subtrahieren des gewichteten Messsignals der dritten Koppeleinheit (K3) von dem gewichteten Messsignal der vierten Koppeleinheit; oder
- durch Subtrahieren eines digitalisierten gewichteten Messsignals der dritten Koppeleinheit (K3) von einem digitalisierten gewichteten Messsignal der vierten Koppeleinheit; und
- Bestimmen des dritten Kennwerts für die scheinbare Ladung aus dem weiteren Differenzsignal.

8. Verfahren nach einem der Ansprüche 1 bis 7, außerdem umfassend:
- Bestimmen einer ersten Laufzeit aus dem Messsignal der ersten Koppeleinheit (K1) und/oder dem Messsignal der zweiten Koppeleinheit (K2);
- Bestimmen einer zweiten Laufzeit aus dem Messsignal der dritten Koppeleinheit (K3);
- Ortung einer Teilentladung des Kabels (GK) basierend auf der ersten Laufzeit und/oder der zweiten Laufzeit.

9. Verfahren nach einem der Ansprüche 1 bis 7, außerdem umfassend:
- Erzeugen eines korrelierten Signals durch Bilden einer Kreuzkorrelation zwischen dem Messsignal der ersten Koppeleinheit (K1) und dem Messsignal der dritten Koppeleinheit (K3) oder zwischen dem Messsignal der zweiten Koppeleinheit (K2) und dem Messsignal der dritten Koppeleinheit (K3);
- Bestimmen einer Laufzeit aus dem korrelierten Signal;
- Ortung einer Teilentladung des Kabels (GK) basierend auf der Laufzeit.

10. Verfahren nach einem der Ansprüche 1 bis 9, weiterhin umfassend das Kalibrieren wenigstens einer der Koppeleinheiten (K1, K2, K3) vor den Schritten der Bereitstellung der Prüfspannung, dem Abgreifen der Messsignale und dem Bestimmen des wenigstens einen Kennwerts.

11. Verfahren nach Anspruch 10, wobei die Koppeleinheiten (K1, K2, K3) jeweils einen Referenzanschluss (R) aufweisen, der mit einem Referenzpotential verbunden ist und das Kalibrieren umfasst:
- Erzeugen eines Kalibrierimpulses zwischen der ersten Anschlussstelle (AL1) der Seele und dem Referenzpotential oder zwischen der ersten Anschlussstelle (Al1) der Seele und einem der Eingänge (E) der Koppeleinheiten (K1, K2, K3) oder zwischen einer weiteren Anschlussstelle der Seele und einem der Eingänge der Koppeleinheiten;
- Abgreifen eines Kalibrationssignals an dem Signalausgang (S) einer der Koppeleinheiten (K1, K2, K3);
- Bestimmen eines Prüfwerts für die scheinbare Ladung des Kalibrierimpulses aus dem Kalibrationssignal; und
- Bestimmen eines Kalibrierfaktors für die Koppeleinheit (K1, K2, K3) an deren Signalausgang (S) das Kalibrationssignal abgegriffen wurde durch Vergleich des Prüfwerts mit einem Referenzwert für die scheinbare Ladung des Kalibrierimpulses.

12. Prüfvorrichtung zur Messung von Teilentladungsimpulsen eines geschirmten Kabels (GK) mit einer Seele und einem Schirm, die Prüfvorrichtung umfassend:
- eine erste, eine zweite und eine dritte Koppeleinheit (K1, K2, K3), umfassend jeweils einen Eingang (E) und einen Signalausgang (S), der Eingang (E) der zweiten Koppeleinheit (K2) zur Verbindung mit einer ersten Anschlussstelle (AS1) des Schirms und der Eingang (E) der dritten Koppeleinheit (K3) zur Verbindung mit einer zweiten Anschlussstelle (AS2) des Schirms, sodass der Schirm nicht direkt, sondern über die zweite und die dritte Koppeleinheit (K2, K3) geerdet ist;
- eine Hochspannungsquelle (HV) mit einem Ausgang zum Anschließen der Hochspannungsquelle an eine erste Anschlussstelle (AL1) der Seele und zur Bereitstellung einer Prüfspannung an dem Ausgang;
- einen mit dem Ausgang der Hochspannungsquelle verbundenen Koppelkondensator (KK), wobei der Eingang (E) der ersten Koppeleinheit mit dem Koppelkondensator (KK) verbunden ist; und
- eine Auswerteeinheit (A), die mit den Signalausgängen (S) der ersten, der zweiten und der dritten Koppeleinheit (K1, K2, K3) verbunden ist;
- wobei die Auswerteeinheit (A) dazu eingerichtet ist, von den Signalausgängen (S) der Koppeleinheiten (K1, K2, K3) wenigstens zwei zugehörige Messsignale zu erhalten und in Abhängigkeit von den wenigstens zwei Messsignalen wenigstens einen Kennwert für eine scheinbare Ladung eines Teilentladungsimpulses des Kabels (GK) zu bestimmen;
wobei
- die wenigstens zwei Messsignale miteinander verrechnet werden.

13. Prüfvorrichtung nach Anspruch 12, wobei jede der Koppeleinheiten (K1, K2, K3) einen mit einem Referenzpotential verbundenen Referenzanschluss (R) aufweist und
- ein induktives Element (IE, SW) beinhaltet, welches zwischen Eingang (E) und Referenzanschluss (R) der jeweiligen Koppeleinheit (K1, K2, K3) angeordnet ist; und/oder
- ein Filterelement (F) beinhaltet, welches zwischen Eingang (E) und Signalausgang (S) der jeweiligen Koppeleinheit (K1, K2, K3) angeordnet ist.

14. Prüfvorrichtung nach Anspruch 13, wobei die Filterelemente (F) der Koppeleinheiten (K1, K2, K3) als adaptive Filterelemente (F) ausgebildet und dazu eingerichtet sind, ihren jeweiligen Frequenzgang an das geschirmte Kabel (GK) derart anzupassen, dass Übertragungsfunktionen eines ersten Messzweigs, der durch die zweite Koppeleinheit (K2) gebildet wird, und eines zweiten Messzweigs, der durch die dritte Koppeleinheit (K3) gebildet wird, sowie eines Koppelzweigs, der den Koppelkondensator (KK) und die erste Koppeleinheit (K1) beinhaltet, einander angeglichen werden.

15. Prüfvorrichtung nach Anspruch 14, außerdem umfassend:
- eine vierte Koppeleinheit, die einen Eingang (E) und einen Signalausgang (S) aufweist; und
- einen weiteren Koppelkondensator verbindbar mit einer zweiten Anschlussstelle (AL2) der Seele, wobei der Eingang (E) der vierten Koppeleinheit mit dem weiteren Koppelkondensator verbunden ist;
- wobei die Auswerteeinheit (A) dazu eingerichtet ist, von dem Signalausgang (S) der vierten Koppeleinheit ein Messsignal zu erhalten und den wenigstens einen Kennwert für eine scheinbare Ladung in Abhängigkeit von dem Messsignal der vierten Koppeleinheit zu bestimmen.

## Claims

1. Method for measuring partial discharge pulses of a shielded cable (GK) having a core and a shield, the method comprising:
- connecting a coupling capacitor (KK) to a first connection point (AL1) of the core;
- providing a first, a second and a third coupling unit (K1, K2, K3), wherein the coupling units (K1, K2, K3) each have an input (E) and a signal output (S) ;
- connecting the input (E) of the first coupling unit (K1) to the coupling capacitor (KK), the input (E) of the second coupling unit (K2) to a first connection point (AS1) of the shield and the input (E) of the third coupling unit (K3) to a second connection point (AS2) of the shield in such a way that the shield is earthed via the second and third coupling units (K2, K3) rather than directly;
- providing a test voltage at the first connection point (AL1) of the core;
- tapping off at least two measurement signals of the coupling units (K1, K2, K3) at the signal outputs (S) of the coupling units (K1, K2, K3);
- determining at least one characteristic value for an apparent charge of a partial discharge pulse of the cable (GK) in a manner dependent on the measurement signals;
wherein
- at least two of the measurement signals are computed with one another.

2. Method according to Claim 1, wherein determining the at least one characteristic value for the apparent charge comprises:
- weighting the measurement signal of the first coupling unit (K1);
- weighting the measurement signal of the second coupling unit (K2) and/or the measurement signal of the third coupling unit (K3);
- generating a difference signal
- by subtracting the weighted measurement signal of the second and/or of the third coupling unit (K2, K3) from the weighted measurement signal of the first coupling unit (K1); or
- by subtracting a digitized weighted measurement signal of the second and/or of the third coupling unit (K2, K3) from a digitized weighted measurement signal of the first coupling unit (K1); and
- determining a first characteristic value for the apparent charge from the difference signal.

3. Method according to Claim 2, wherein determining the first characteristic value for the apparent charge from the difference signal comprises integration at least of a part of the difference signal or of a signal derived from the difference signal.

4. Method according to any of Claims 1 to 3, wherein determining the at least one characteristic value for the apparent charge comprises determining at least one second characteristic value for the apparent charge from the measurement signal of the second coupling unit (K2) and/or the measurement signal of the third coupling unit (K3).

5. Method according to Claim 4, wherein determining the at least one second characteristic value for the apparent charge comprises:
- weighting the measurement signal of the second coupling unit (K2) and the measurement signal of the third coupling unit (K3);
- generating a summation signal by addition of the weighted measurement signals of the second and third coupling units (K2, K3) or the Fourier spectra of the weighted measurement signals of the second and third coupling units (K2, K3); and
- determining the second characteristic value for the apparent charge from the summation signal.

6. Method according to any of Claims 1 to 5, additionally comprising:
- providing a fourth coupling unit having an input (E) and a signal output (S);
- connecting a further coupling capacitor to a second connection point of the core (AL2) and the input of the fourth coupling unit to the further coupling capacitor;
- tapping off a measurement signal of the fourth coupling unit at the signal output (S) of the fourth coupling unit;
- determining a third characteristic value for the apparent charge in a manner dependent on the measurement signal of the fourth coupling unit.

7. Method according to Claim 6, wherein determining the third characteristic value for the apparent charge comprises:
- weighting the measurement signals of the third coupling unit (K3) and the fourth coupling unit;
- generating a further difference signal
- by subtracting the weighted measurement signal of the third coupling unit (K3) from the weighted measurement signal of the fourth coupling unit; or
- by subtracting a digitized weighted measurement signal of the third coupling unit (K3) from a digitized weighted measurement signal of the fourth coupling unit; and
- determining the third characteristic value for the apparent charge from the further difference signal.

8. Method according to any of Claims 1 to 7, additionally comprising:
- determining a first propagation time from the measurement signal of the first coupling unit (K1) and/or the measurement signal of the second coupling unit (K2);
- determining a second propagation time from the measurement signal of the third coupling unit (K3);
- locating a partial discharge of the cable (GK) on the basis of the first propagation time and/or the second propagation time.

9. Method according to any of Claims 1 to 7, additionally comprising:
- generating a correlated signal by forming a crosscorrelation between the measurement signal of the first coupling unit (K1) and the measurement signal of the third coupling unit (K3) or between the measurement signal of the second coupling unit (K2) and the measurement signal of the third coupling unit (K3);
- determining a propagation time from the correlated signal;
- locating a partial discharge of the cable (GK) on the basis of the propagation time.

10. Method according to any of Claims 1 to 9, furthermore comprising calibrating at least one of the coupling units (K1, K2, K3) before the steps of providing the test voltage, tapping off the measurement signals and determining the at least one characteristic value.

11. Method according to Claim 10, wherein the coupling units (K1, K2, K3) each have a reference connection (R) connected to a reference potential, and the calibrating comprises:
- generating a calibrating pulse between the first connection point (AL1) of the core and the reference potential or between the first connection point (AL1) of the core and one of the inputs (E) of the coupling units (K1, K2, K3) or between a further connection point of the core and one of the inputs of the coupling units;
- tapping off a calibration signal at the signal output (S) of one of the coupling units (K1, K2, K3) ;
- determining a test value for the apparent charge of the calibrating pulse from the calibration signal; and
- determining a calibrating factor for the coupling unit (K1, K2, K3) at whose signal output (S) the calibration signal was tapped off, by comparing the test value with a reference value for the apparent charge of the calibrating pulse.

12. Test device for measuring partial discharge pulses of a shielded cable (GK) having a core and a shield, the test device comprising:
- a first, a second and a third coupling unit (K1, K2, K3), each comprising an input (E) and a signal output (S), the input (E) of the second coupling unit (K2) serving for being connected to a first connection point (AS1) of the shield and the input (E) of the third coupling unit (K3) serving for being connected to a second connection point (AS2) of the shield, such that the shield is earthed via the second and third coupling units (K2, K3) rather than directly;
- a high-voltage source (HV) having an output for connecting the high-voltage source to a first connection point (AL1) of the core and for providing a test voltage at the output;
- a coupling capacitor (KK) connected to the output of the high-voltage source, wherein the input (E) of the first coupling unit is connected to the coupling capacitor (KK); and
- an evaluation unit (A) connected to the signal outputs (S) of the first, second and third coupling units (K1, K2, K3);
- wherein the evaluation unit (A) is configured to acquire at least two associated measurement signals from the signal outputs (S) of the coupling units (K1, K2, K3) and to determine at least one characteristic value for an apparent charge of a partial discharge pulse of the cable (GK) in a manner dependent on the at least two measurement signals;
wherein
- the at least two measurement signals are computed with one another.

13. Test device according to Claim 12, wherein each of the coupling units (K1, K2, K3) has a reference connection (R) connected to a reference potential and
- includes an inductive element (IE, SW) arranged between input (E) and reference connection (R) of the respective coupling unit (K1, K2, K3); and/or
- includes a filter element (F) arranged between input (E) and signal output (S) of the respective coupling unit (K1, K2, K3).

14. Test device according to Claim 13, wherein the filter elements (F) of the coupling units (K1, K2, K3) are embodied as adaptive filter elements (F) and are configured to adapt their respective frequency response to the shielded cable (GK) in such a way that transfer functions of a first measurement branch, which is formed by the second coupling unit (K2), and of a second measurement branch, which is formed by the third coupling unit (K3), and also of a coupling branch, which includes the coupling capacitor (KK) and the first coupling unit (K1), are matched to one another.

15. Test device according to Claim 14, additionally comprising:
- a fourth coupling unit having an input (E) and a signal output (S); and
- a further coupling capacitor connectable to a second connection point (AL2) of the core, wherein the input (E) of the fourth coupling unit is connected to the further coupling capacitor;
- wherein the evaluation unit (A) is configured to acquire a measurement signal from the signal output (S) of the fourth coupling unit and to determine the at least one characteristic value for an apparent charge in a manner dependent on the measurement signal of the fourth coupling unit.

## Revendications

1. Procédé permettant de mesurer des impulsions de décharge partielle d'un câble blindé (GK) pourvu d'une âme et d'un blindage, le procédé comprenant les étapes consistant à :
- relier un condensateur de couplage (KK) à un premier point de connexion (AL1) de l'âme ;
- fournir une première, une deuxième et une troisième unité de couplage (K1, K2, K3), dans lequel les unités de couplage (K1, K2, K3) présentent respectivement une entrée (E) et une sortie de signal (S) ;
- relier l'entrée (E) de la première unité de couplage (K1) au condensateur de couplage (KK), l'entrée (E) de la deuxième unité de couplage (K2) à un premier point de connexion (AS1) du blindage, et l'entrée (E) de la troisième unité de couplage (K3) à un deuxième point de connexion (AS2) du blindage de telle sorte que le blindage n'est pas mis à la terre directement mais par l'intermédiaire de la deuxième et de la troisième unité de couplage (K2, K3) ;
- fournir une tension d'essai au premier point de connexion (AL1) de l'âme ;
- prélever au moins deux signaux de mesure des unités de couplage (K1, K2, K3) aux sorties de signal (S) des unités de couplage (K1, K2, K3) ;
- déterminer au moins une valeur caractéristique d'une charge apparente d'une impulsion de charge partielle du câble (GK) en fonction des signaux de mesure ;
dans lequel
- au moins deux des signaux de mesure se compensent.

2. Procédé selon la revendication 1, dans lequel la détermination de ladite au moins une valeur caractéristique pour la charge apparente comprend :
- pondérer le signal de mesure de la première unité de couplage (K1) ;
- pondérer le signal de mesure de la deuxième unité de couplage (K2) et/ou le signal de mesure de la troisième unité de couplage (K3) ;
- générer un signal de différence
- en soustrayant le signal de mesure pondéré de la deuxième et/ou de la troisième unité de couplage (K2, K3) du signal de mesure pondéré de la première unité de couplage (K1) ; ou
- en soustrayant un signal de mesure pondéré numérisé de la deuxième et/ou de la troisième unité de couplage (K2, K3) d'un signal de mesure pondéré numérisé de la première unité de couplage (K1) ; et
- déterminer une première valeur caractéristique pour la charge apparente à partir du signal de différence.

3. Procédé selon la revendication 2, dans lequel la détermination de la première valeur caractéristique pour la charge apparente à partir du signal de différence comprend une intégration au moins d'une partie du signal de différence ou d'un signal dérivé du signal de différence.

4. Procédé selon l'une quelconque des revendications 1 à 3, dans lequel la détermination de ladite au moins une valeur caractéristique pour la charge apparente comprend la détermination au moins d'une deuxième valeur caractéristique pour la charge apparente à partir du signal de mesure de la deuxième unité de couplage (K2) et/ou du signal de mesure de la troisième unité de couplage (K3).

5. Procédé selon la revendication 4, dans lequel la détermination de ladite au moins une deuxième valeur caractéristique pour la charge apparente comprend :
- pondérer le signal de mesure de la deuxième unité de couplage (K2) et le signal de mesure de la troisième unité de couplage (K3) ;
- générer un signal de somme en additionnant les signaux de mesure pondérés de la deuxième et de la troisième unité de couplage (K2, K3) ou les spectres de Fourier des signaux de mesure pondérés de la deuxième et de la troisième unité de couplage (K2, K3) ; et
- déterminer la deuxième valeur caractéristique pour la charge apparente à partir du signal de somme.

6. Procédé selon l'une quelconque des revendications 1 à 5, comprenant en outre :
- fournir une quatrième unité de couplage qui présente une entrée (E) et une sortie de signal (S) ;
- relier un condensateur de couplage supplémentaire à un deuxième point de connexion de l'âme (AL2) et de l'entrée de la quatrième unité de couplage à un condensateur de couplage supplémentaire ;
- prélever des signaux de mesure de la quatrième unité de couplage à la sortie de signal (S) de la quatrième unité de couplage ;
- déterminer une troisième valeur caractéristique pour la charge apparente en fonction du signal de mesure de la quatrième unité de couplage.

7. Procédé selon la revendication 6, dans lequel la détermination de la troisième valeur caractéristique pour la charge apparente comprend :
- pondérer les signaux de mesure de la troisième (K3) et de la quatrième unité de couplage ;
- générer un signal de différence supplémentaire
- en soustrayant le signal de mesure pondéré de la troisième unité de couplage (K3) du signal de mesure pondéré de la quatrième unité de couplage ; ou
- en soustrayant un signal de mesure pondéré numérisé de la troisième unité de couplage (K3) d'un signal de mesure pondéré numérisé de la quatrième unité de couplage ; et
- déterminer la troisième valeur caractéristique pour la charge apparente à partir du signal de différence supplémentaire.

8. Procédé selon l'une quelconque des revendications 1 à 7, comprenant en outre :
- déterminer un premier temps de propagation à partir du signal de mesure de la première unité de couplage (K1) et/ou du signal de mesure de la deuxième unité de couplage (K2) ;
- déterminer un deuxième temps de propagation à partir du signal de mesure de la troisième unité de couplage (K3) ;
- localiser une décharge partielle du câble (GK) sur la base du premier temps de propagation et/ou du deuxième temps de propagation.

9. Procédé selon l'une quelconque des revendications 1 à 7, comprenant en outre :
- générer un signal corrélé en formant une corrélation croisée entre le signal de mesure de la première unité de couplage (K1) et le signal de mesure de la troisième unité de couplage (K3) ou entre le signal de mesure de la deuxième unité de couplage (K2) et le signal de mesure de la troisième unité de couplage (K3) ;
- déterminer un temps de propagation à partir du signal corrélé ;
- localiser une décharge partielle du câble (GK) sur la base du temps de propagation.

10. Procédé selon l'une quelconque des revendications 1 à 9, comprenant en outre l'étalonnage d'au moins l'une des unités de couplage (K1, K2, K3) avant les étapes de fourniture de la tension d'essai, du prélèvement des signaux de mesure et de la détermination de ladite au moins une valeur caractéristique.

11. Procédé selon la revendication 10, dans lequel les unités de couplage (K1, K2, K3) présentent respectivement une connexion de référence (R) qui est reliée à un potentiel de référence, et l'étalonnage comprend :
- générer une impulsion d'étalonnage entre le premier point de connexion (AL1) de l'âme et le potentiel de référence ou entre le premier point de connexion (AL1) de l'âme et l'une des entrées (E) des unités de couplage (K1, K2, K3) ou entre un point de connexion supplémentaire de l'âme et l'une des entrées des unités de couplage ;
- prélever un signal d'étalonnage à la sortie de signal (S) d'une des unités de couplage (K1, K2, K3) ;
- déterminer une valeur de contrôle pour la charge apparente de l'impulsion d'étalonnage à partir du signal d'étalonnage ; et
- déterminer un facteur d'étalonnage pour l'unité de couplage (K1, K2, K3) à la sortie de signal (S) de laquelle le signal d'étalonnage a été prélevé en comparant la valeur de contrôle avec une valeur de référence pour la charge apparente de l'impulsion d'étalonnage.

12. Dispositif de contrôle permettant de mesurer des impulsions de décharge partielle d'un câble blindé (GK) pourvu d'une âme et d'un blindage, le dispositif de contrôle comprenant :
- une première, une deuxième et une troisième unité de couplage (K1, K2, K3) comprenant respectivement une entrée (E) et une sortie de signal (S), l'entrée (E) de la deuxième unité de couplage (K2) servant à la liaison à un premier point de connexion (AS1) du blindage et l'entrée (E) de la troisième unité de couplage (K3) servant à la liaison à un deuxième point de connexion (AS2) du blindage de sorte que le blindage n'est pas mis à la terre directement mais par l'intermédiaire de la deuxième et de la troisième unité de couplage (K2, K3) ;
- une source de haute tension (HV) pourvue d'une sortie pour la connexion de la source de haute tension à un premier point de connexion (AL1) de l'âme et pour la fourniture d'une tension d'essai à la sortie ;
- un condensateur de couplage (KK) relié à la sortie de la source de haute tension, dans lequel l'entrée (E) de la première unité de couplage est reliée au condensateur de couplage (KK) ; et
- une unité d'évaluation (A) qui est reliée aux sorties de signal (S) de la première, de la deuxième et de la troisième unité de couplage (K1, K2, K3) ;
- dans lequel l'unité d'évaluation (A) est conçue pour obtenir au moins deux signaux de mesure associés à partir des sorties de signal (S) des unités de couplage (K1, K2, K3) et pour déterminer en fonction des au moins deux signaux de mesure au moins une valeur caractéristique pour une charge apparente d'une impulsion de décharge partielle du câble (GK) ;
dans lequel
- les au moins deux signaux de mesure se compensent.

13. Dispositif de contrôle selon la revendication 12, dans lequel chacune des unités de couplage (K1, K2, K3) présente une connexion de référence (R) relié à un potentiel de référence et
- comporte un élément inductif (IE, SW) qui est disposé entre l'entrée (E) et la connexion de référence (R) de l'unité de couplage (K1, K2, K3) respective ; et/ou
- comporte un élément filtrant (F) qui est disposé entre l'entrée (E) et la sortie de signal (S) de l'unité de couplage (K1, K2, K3) respective.

14. Dispositif de contrôle selon la revendication 13, dans lequel les éléments filtrants (F) des unités de couplage (K1, K2, K3) sont réalisés comme des éléments filtrants adaptatifs (F) et sont conçus pour adapter leur réponse fréquentielle respective au câble blindé (GK) de telle sorte que des fonctions de transmission d'une première branche de mesure formée par la deuxième unité de couplage (K2) et d'une deuxième branche de mesure formée par la troisième unité de couplage (K3) ainsi que d'une branche de couplage qui comporte le condensateur de couplage (KK) et la première unité de couplage (K1) sont harmonisées.

15. Dispositif de contrôle selon la revendication 14, comprenant en outre :
- une quatrième unité de couplage qui présente une entrée (E) et une sortie de signal (S) ; et
- un condensateur de couplage supplémentaire qui peut être relié à un deuxième point de connexion (AL2) de l'âme, dans lequel l'entrée (E) de la quatrième unité de couplage est reliée à l'autre condensateur de couplage ;
- dans lequel l'unité d'évaluation (A) est conçue pour obtenir de la sortie de signal (S) de la quatrième unité de couplage un signal de mesure et pour déterminer ladite au moins une valeur caractéristique pour une charge apparente en fonction du signal de mesure de la quatrième unité de couplage.
